(19) **Europäisches Patentamt**

**European Patent Office**

**Office européen des brevets**

(11) **EP 1 686 678 A1**

(12) **EUROPÄISCHE PATENTANMELDUNG**

(43) Veröffentlichungstag:
02.08.2006 Patentblatt 2006/31

(51) Int Cl.:
*H02M 1/12* *(2006.01)*

(21) Anmeldenummer: 05023201.6

(22) Anmeldetag: 25.10.2005

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **27.01.2005 DE 102005004177**

(71) Anmelder: **Nordseewerke GmbH**
**22767 Hamburg (DE)**

(72) Erfinder: **Harms, Harm-Friedrich**
**26632 Ihlow (DE)**

(74) Vertreter: **Hansmann, Dierk et al**
**Jessenstrasse 4**
**22767 Hamburg (DE)**

(54) **Anordnung zur Dämpfung oder Kompensation leitungsgebundener Gleichtaktstörungen**

(57)     Bei Leitungssystemen mit auftretenden asymmetrischen Störströmen ist vorgesehen, durch aktive EMV-Filter eine Dämpfung und/oder Kompensation herbeizuführen. Hierbei ist das Leitungssystem mit Hin- und Rückleitern über Auskopplungsübertrager zur Erfassung der Störströme geführt und durch einen Einkopplungsübertrager unter Zwischenschaltung eines invertierenden Verstärkers sind Ströme gegenphasig wieder zuführbar.

EP 1 686 678 A1

**Beschreibung**

Die Erfindung bezieht sich auf eine Anordnung zur Dämpfung und/oder Kompensation leitungsgebundener asymmetrischer Störströme eines Leitungssystems für Leitungen stationärer Anlagen, insbesondere in Fahrzeugen, wie in Marinefahrzeugen, durch die Verwendung von Filtern.

Die Forderungen nach hoher Antriebsdynamik, Betrieb mit variablen Drehzahlen, Wartungs- und Geräuscharmut sowie nach einer möglichst hohen Schutzklasse werden durch die Kombination von Drehstrommotor und Frequenzumrichter erfüllt. Der Frequenzumrichter bietet hierbei derzeit eine günstige technische Möglichkeit der verlustarmen Drehzahlregelung über die Erzeugung eines frequenz- und spannungsvariablen Drehstroms zur Speisung eines Motors. Gleiches gilt für einen Servomotor in Verbindung mit einem Servoumrichter. Beim drehzahlvariablen Drehstromantrieb mit Frequenzumrichter entstehen aufgrund der "schnellen" Schaltvorgänge und infolge großer Koppelkapazitäten gegen Masse hohe Störpegel. Diese Störungen breiten sich unter anderem als leitungsgebunde asymmetrische Störströme auf Leitungssystemen aus.

Der zunehmende Einsatz von Schaltnetzteilen und Frequenzumrichtern in elektrischen Netzen führt zu einer Verschlechterung der Netzqualität. Die Verschlechterung hat zur Folge, daß andere Geräte gestört oder sogar zerstört werden können. Um einen sicheren Betrieb der einzelnen Geräte zu gewährleisten, müssen sie einerseits als Störsenke eine gewisse Immunität gegen Störeinflüsse haben und andererseits dürfen sie als Störquelle keine anderen Geräte beeinträchtigen. Die Betrachtung der "Elektromagnetischen Verträglichkeit", kurz EMV, ist daher nicht nur auf einzelne Geräte beschränkt, sondern umfaßt oft ein sehr komplexes System. Zur Verminderungen der Störeinflüsse auf Leitungssystemen werden verschiedene Maßnahmen, wie Filter, eingesetzt. Erfahrungen im Marineschiffbau zeigen, daß klassische Filtermaßnahmen nicht immer zu einem befriedigenden Ergebnis führen. Störungen, die durch Wechselrichter für Antriebe verursacht werden, führen zu Problemen bei der Funkübertragung. Bei Leitungssystemen, die beispielsweise als Versorgungsleitungen für große Ströme und Spannungen verwendet werden, werden klassische Filter, die mit Spulen und Kondensatoren ausgestattet sind, sehr kostspielig, groß und schwer. Aus der benötigten Strom- und Spannungsfestigkeit resultiert, daß eine Filterung durch klassische passive Filter die Ausmaße der Filter so groß werden lassen, daß ein Einbau eines passiven Filters beispielsweise im U-Boot nicht durchführbar ist.

Die Aufgabe der Erfindung ist es, Störeinflüsse auf Leitungssystemen durch asymmetrische Störströme auf einfache Weise über Filter zu dämpfen und/oder zu kompensieren und dabei eine ökonomische platzsparende Anwendung und Ausbildung zu ermöglichen.

Die Lösung dieser Aufgabe erfolgt erfindungsgemäß dadurch, daß als Filter die Leitung mit Hin- und Rückleitern über Auskopplungsübertrager zur Erfassung der Störströme geführt und durch einen Einkopplungsübertrager unter Zwischenschaltung eines invertierenden Verstärkers Ströme gegenphasig wieder zuführbar sind.

Hierdurch wird ein aktives Filter geschaffen, das mit geringem Aufwand eine Dämpfung und/oder Kompensation leitungsgebundener asymmetrischer Störströme gewährleistet, dessen Ausmaße relativ klein sind, um auch einen Fahrzeugeinbau zu gewährleisten.

Eine günstige Ausbildung besteht darin, daß der Auskopplungsübertrager aus einer Ringkernspule gebildet ist und der Einkopplungsübertrager aus einen der Leitung zugeordneten Leiter, wobei der Leiter Massepunkte verbindet.

Ferner ist alternativ vorgesehen, daß die Aus- und Einkopplungsübertrager aus separaten Ringkernspulen bestehen.

Zusätzlich ist vorgesehen, daß die Aus- und Einkopplungsübertrager (2, 4) identisch sind.

weiterhin wird vorgeschlagen, daß der invertierende Verstärker aus mindestens einem Operationsverstärker besteht.

Eine Ausgestaltung mit guten Optimierungsmöglichkeiten besteht darin, daß der Verstärker aus einem invertierenden Vorverstärker und einem Endverstärker besteht.

In der Zeichnung sind Ausführungsbeispiele der Erfindung schematisch dargestellt. Es zeigen:

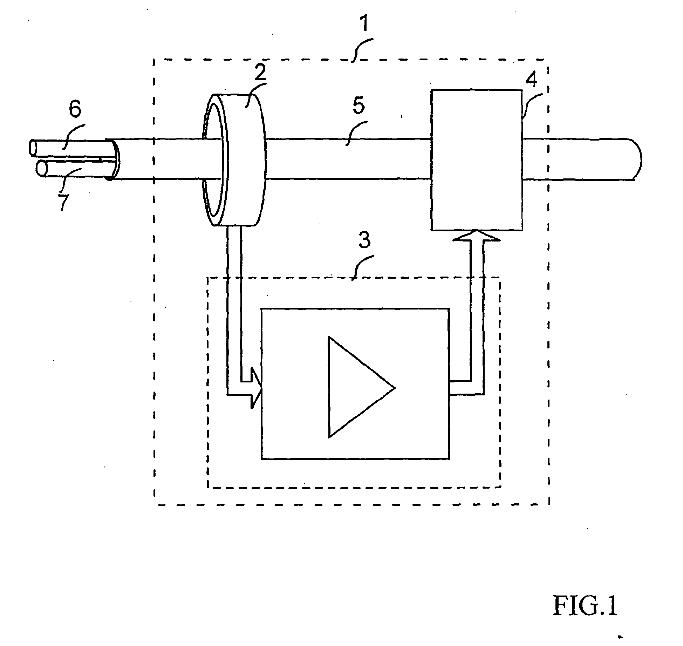

Fig. 1    ein Blockschaltbild einer ersten Ausführungsform als Prinzipdarstellung,

Fig. 2    eine Konkretisierung einer Ausführung mit einem Leiter als Einkopplungsübertrager,

Fig. 3    eine alternative Ausbildung gemäß Fig. 2,

Fig. 4    eine Ausführung mit Ringkernspulen zur Ein- und Auskopplung,

Fig. 5    eine Ausbildung mit einer Ringkernspule zur Ein- und Auskopplung,

Fig. 6    eine konkretisierte Ausbildung gemäß Fig. 4

Die dargestellte Schaltungsanordnung eines aktiven EMV-Filters 1 besteht aus einem Auskopplungsübertrager 2, einem invertierenden Verstärker 3 und einem Einkopplungsübertrager 4. Der Auskopplungsübertrager 2 besteht aus einer Ringkernspule, wobei die Ringerkernspule zur common-mode-Messung der asymmetrischen Störströme eines Leitungssystems 5 dient. Das Leitungssystem 5 besteht aus einem oder mehreren Hin- und Rückleitern 6, 7 mit oder ohne Abschirmung. Der invertierende Verstärker 3 verstärkt die von dem Auskopplungsübertrager 2 gemessenen Signale, die die asymmetrischen Störströme des Leitungssystems 5 repräsentieren und werden als verstärkte Signale invers, also gegenphasig gegenüber der Phasenlage der asymmetrischen Störströme in das Leitungssystem 5 mit dem Einkopplungsübertrager 4 eingekoppelt, um somit die asymmetrischen Störströme zu dämpfen und oder zu kompensieren.

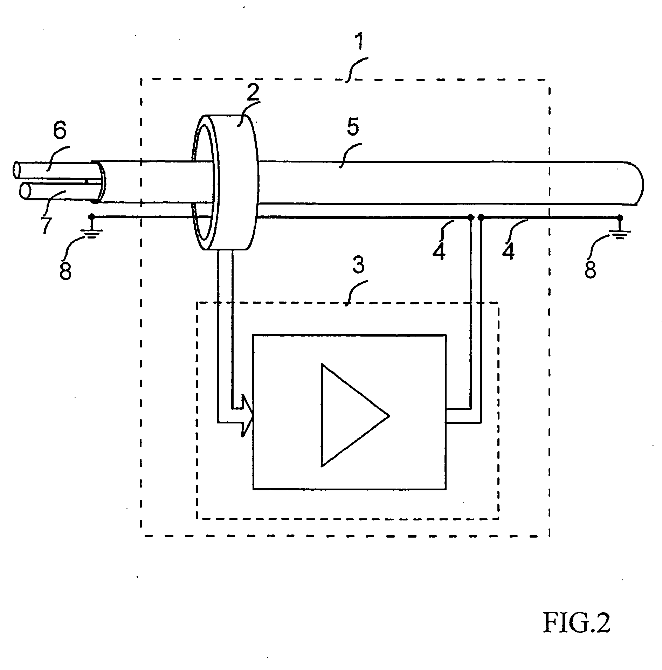

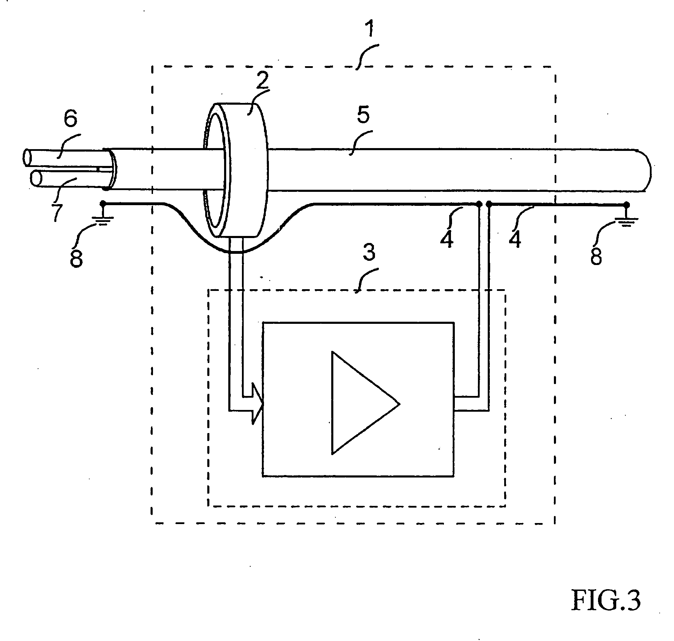

Wie in Fig. 2 dargestellt, ist zur Realisierung des Einkopplungsübertragers 4 ein Leiter angeordnet. Der Leiter verbindet zwei Massepunkte 8 an den Gerätegehäusen an den Enden des Kabels und ist in örtlicher Nähe zum Leitungssystem 5 installiert. Hierbei besteht die Möglichkeit, den Leiter durch den Ringkern des Auskopplungsübertragers 2 oder neben dem Ringkern des Auskopplungsübertragers 2 zu führen, wie es in Fig. 3 gezeigt ist.

Die einfache Realisierung eines Einkopplungsübertragers 4 mit einem Leiter 9 ist die Verwendung eines Leiters im Leitungssystem 5, der ausschließlich für diesen Zweck zu verwenden ist. Falls das Leitungssystem eine Schirmung aufweist, kann die Schirmung auch in der Funktion eines Einkopplungsübertragers dienen.

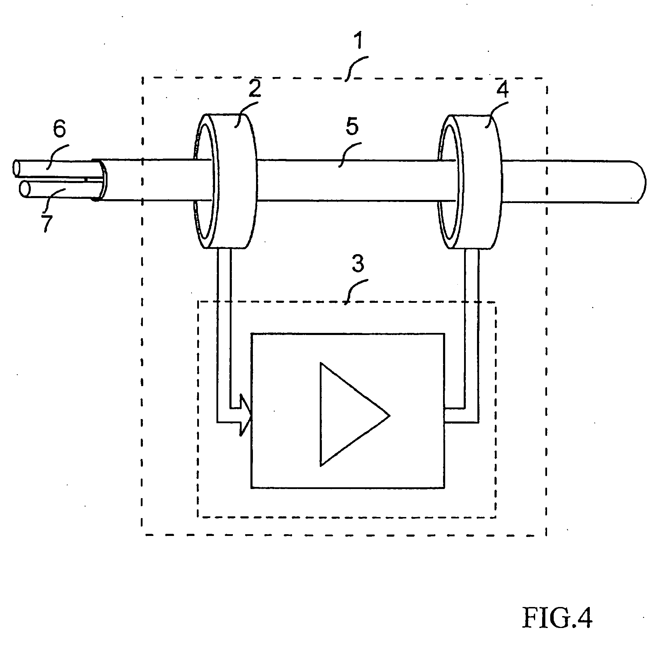

In Fig. 4 ist eine weitere Ausführungsform des Einkopplungsübertragers 4 dargestellt. Hierbei besteht der Aus- und Einkopplungsübertrager 2, 4 jeweils aus einer Ringkernspule.

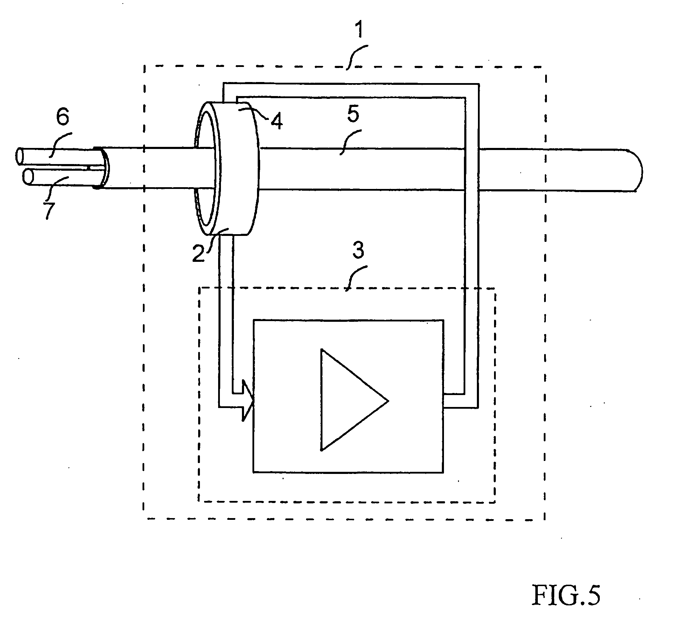

Gemäß Fig. 5 ist eine weitere Ausführung mit einem Ringkern 4 zur Aus- und Einkopplung vorgesehen.

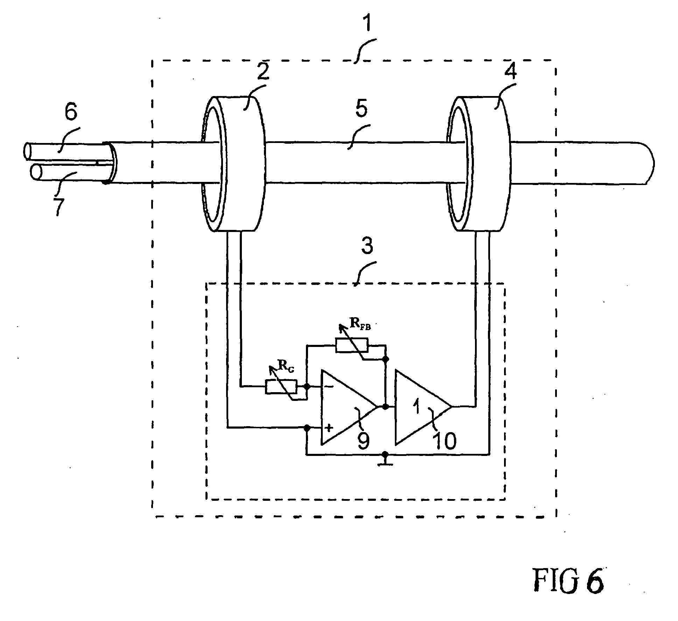

Der invertierende Verstärker 3 ist gemäß Fig. 6 mit speziellen Operationsverstärkern realisiert. Der invertierende Verstärker 3 besteht bei der Konkretisierung aus einem invertierenden Vorverstärker 9 und einem Endverstärker 10. Der invertierende Vorverstärker 9 kann beispielsweise aus einem sogenannten Current-Feedback Operational Amplifier aufgebaut sein.

Die Verstärkung A der gegengekoppelten Schaltung (closed loop gain) des Current-Feedback Operational Amflifier als invertierendem Vorverstärker berechnet sich vereinfacht mit:

$$A = - \frac{R_{FB}}{R_G}$$

Im Unterschied zum Voltage-Feedback-Operational-Amplifier wo die Grenzfrequenz um so kleiner wird, je größer die Verstärkung ist, wird die Grenzfrequenz beim Current-Feedback-Operational-Amplifier durch den Feedback-Resistor bestimmt $R_{FB}$. Die Bandbreite wird also in erster Linie durch den Feedback-Resistor $R_{FB}$ festgelegt und die Verstärkung mit dem Gain-Resistor $R_G$ entsprechend der angegebenen Gleichung eingestellt. Um die Verstärkung zu erhöhen wird der Gain-Resistor $R_G$ verkleinert, wobei sich die Leerlaufverstärkung durch Reduzierung der Stromgegenkopplung im selben Maß erhöht wie die Verstärkung selbst. Für das aktive EMV-Filter können die beiden widerstände $R_c$, $R_{FB}$, als Potentiometer ausgeführt werden, um die werte für ein optimales Einschwingverhalten individuell einstellen zu können.

Ein spezieller High-Speed Buffer, der als Trennverstärker arbeitet, wird als Endverstärker 10 des invertierenden Verstärkers 3 eingesetzt werden, um den Auskopplungsübertrager 4 mit dem vom invertierenden Vorverstärker 9 verstärkten Signal zu treiben. Bei der Verwendung eines Buffers als Endverstärker 10 wird der invertierende Vorverstärker 9 nicht niederohmig belastet. Der Endverstärker 10 ermöglicht die direkte Versorgung induktiver Lasten. Zur nötigen Kühlung des Endverstärkers kann ein Kühlkörper verwendet werden. Durch die Verwendung von Schutzdioden im Verstärkeraufbau kann das aktive Filter vor zu hohen Versorgungs- und Einkopplungsspannungen geschützt werden.

Die Spannungsversorgung für den invertierenden Verstärker 3 wird beispielsweise durch Spannungsregler realisiert. Je nach Einsatzort kann die Spannung durch einen Adapter an das vorliegende Netz, beispielsweise durch eine Transformatorschaltung oder Schaltnetzschaltung, angepasst werden.

**Patentansprüche**

1. Anordnung zur Dämpfung und/oder Kompensation leitungsgebundener asymmetrischer Störströme eines Leitungssystems für Leitungen stationärer Anlagen, insbesondere in Fahrzeugen, wie in Marinefahrzeugen, durch die Verwendung von Filtern, **dadurch gekennzeichnet, daß** als Filter (1) die Leitung (5) mit Hin- und Rückleitern (6, 7) über Auskopplungsübertrager (2) zur Erfassung der Störströme geführt und durch einen Einkopplungsübertrager (4) unter Zwischenschaltung eines invertierenden Verstärkers (3) Ströme gegenphasig wieder zuführbar sind.

2. Anordnung nach Anspruch 1, **dadurch gekennzeichnet, daß** der Auskopplungsübertrager (2) aus einer Ringkernspule gebildet ist und der Einkopplungsübertrager (4) aus einen der Leitung (5) zugeordneten Leiter (9), wobei der Leiter (9) Massepunkte(8) verbindet.

3. Anordnung nach Anspruch 1, **dadurch gekennzeichnet, daß** die Aus- und Einkopplungsübertrager (2, 4) aus separaten Ringkernspulen bestehen.

4. Anordnung nach Anspruch 1 oder 3, **dadurch gekennzeichnet, daß** die Aus- und Einkopplungsübertrager (2, 4) identisch sind.

5. Anordnung nach einem der Ansprüche 1 bis 4, **dadurch gekennzeichnet, daß** der invertierende Verstärker (3) aus mindestens einem Operationsverstärker besteht.

6.  Anordnung nach einem der Ansprüche 1 bis 5, **dadurch gekennzeichnet, daß** der Verstärker (3) aus einem invertierenden Vorverstärker (9) und einem Endverstärker (10) besteht.

FIG.1

FIG.2

FIG.3

FIG.4

FIG.5

FIG 6

**Europäisches Patentamt**

# EUROPÄISCHER RECHERCHENBERICHT

Nummer der Anmeldung

EP 05 02 3201

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 986 165 A (KABUSHIKI KAISHA TOSHIBA) 15. März 2000 (2000-03-15) | 1,2,5,6 | INV. H02M1/12 |
| Y | * Zusammenfassung * * Absätze [0011], [0012] * * Abbildungen 2-5,7,8 * ----- | 3,4 | |
| Y | US 5 831 842 A (OGASAWARA ET AL) 3. November 1998 (1998-11-03) | 3,4 | |
| X | * Zusammenfassung * * Abbildungen 1,5,6 * ----- | 1 | |
| X | US 2003/210563 A1 (TAKAHASHI TOSHIO ET AL) 13. November 2003 (2003-11-13) * Zusammenfassung * * Abbildungen 1,6,7 * ----- | 1,2,5,6 | |
| X | EP 1 143 602 A (INTERNATIONAL RECTIFIER CORPORATION) 10. Oktober 2001 (2001-10-10) * Zusammenfassung * * Abbildungen 23,24 * ----- | 1,2,5,6 | |
| Y | US 5 936 856 A (XIANG ET AL) 10. August 1999 (1999-08-10) | 3,4 | RECHERCHIERTE SACHGEBIETE (IPC) H02M |
| A | * Zusammenfassung * * Abbildung 6 * ----- | 1,2,5,6 | |
| A | EP 1 271 773 A (TDK CORPORATION) 2. Januar 2003 (2003-01-02) * Zusammenfassung * ----- | 1-6 | |

Der vorliegende Recherchenbericht wurde für alle Patentansprüche erstellt

| Recherchenort | Abschlußdatum der Recherche | Prüfer |
|---|---|---|
| München | 16. Mai 2006 | Krasser, B |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.............................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 05 02 3201

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-05-2006

| Im Recherchenbericht angeführtes Patentdokument | | Datum der Veröffentlichung | Mitglied(er) der Patentfamilie | | Datum der Veröffentlichung |
|---|---|---|---|---|---|
| EP 0986165 | A | 15-03-2000 | CN<br>DE<br>KR<br>US | 1247406 A<br>69928336 D1<br>2000022996 A<br>6134126 A | 15-03-2000<br>22-12-2005<br>25-04-2000<br>17-10-2000 |
| US 5831842 | A | 03-11-1998 | JP<br>JP | 2863833 B2<br>10094244 A | 03-03-1999<br>10-04-1998 |
| US 2003210563 | A1 | 13-11-2003 | KEINE | | |
| EP 1143602 | A | 10-10-2001 | JP<br>JP<br>TW<br>US<br>US | 3428588 B2<br>2002010650 A<br>512574 B<br>2004004514 A1<br>2001045863 A1 | 22-07-2003<br>11-01-2002<br>01-12-2002<br>08-01-2004<br>29-11-2001 |
| US 5936856 | A | 10-08-1999 | KEINE | | |
| EP 1271773 | A | 02-01-2003 | CN<br>WO<br>TW<br>US | 1394387 A<br>0237674 A1<br>516270 B<br>2002063474 A1 | 29-01-2003<br>10-05-2002<br>01-01-2003<br>30-05-2002 |

EPO FORM P0461

Für nähere Einzelheiten zu diesem Anhang : siehe Amtsblatt des Europäischen Patentamts, Nr.12/82